# EUROPEAN PATENT SPECIFICATION

(11) **EP 1 624 087 B1**
(45) Date of publication and mention of the grant of the patent: **14.05.2014**
(21) Application number: 05014446.8
(22) Date of filing: 04.07.2005
(51) Int. Cl.: C23C 14/02, C23C 14/00, C23C 14/08

(54) **A method for depositing thin layers of titanium dioxide on support surfaces**
Verfahren zur Abscheidung von Dünnschichten aus Titaniumoxid auf Trägerflächen
Procédé de dépôt de couches minces d'oxyde de titane sur une surface de support

(30) Priority: 06.08.2004 IT PR20040059
(43) Date of publication of application: 08.02.2006
(73) Proprietor: VACUUM SURTEC S.r.l., 43056 San Polo di Torrile (Parma) (IT)
(72) Inventor: Antolotti, Nelso, 43046 Ozzano Taro (Parma) (IT); Troglio, Sergio, 25131 Brescia (IT); Rizzi, Gabriele, 29017 Fiorenzuola D'Arda (Piacenza) (IT); Scrivani, Andrea, 29100 Piacenza (IT); Ferpozzi, Roberto, San Polo di Torrile (Parma) (IT)
(74) Representative: Gotra, Stefano

(56) References cited:
- EP-A- 1 442 793
- ZHENG S K ET AL: "Photocatalytic activity of nanostructured TiO2 thin films prepared by dc magnetron sputtering method" VACUUM, PERGAMON PRESS, GB, vol. 62, no. 4, 22 June 2001 (2001-06-22), pages 361-366, XP002963475 ISSN: 0042-207X
- ZEMAN P ET AL: "Nano-scaled photocatalytic TiO2 thin films prepared by magnetron sputtering" PREPARATION AND CHARACTERIZATION, ELSEVIER SEQUOIA, NL, vol. 433, no. 1-2, 2 June 2003 (2003-06-02), pages 57-62, XP004428714 ISSN: 0040-6090
- ZEMAN P ET AL: "Self-cleaning and antifogging effects of TiO2 films prepared by radio frequency magnetron sputtering" JOURNAL OF VACUUM SCIENCE AND TECHNOLOGY A. VACUUM, SURFACES AND FILMS, AMERICAN INSTITUTE OF PHYSICS, NEW YORK, NY, US, vol. 20, no. 2, March 2002 (2002-03), pages 388-393, XP012005968 ISSN: 0734-2101
- PATENT ABSTRACTS OF JAPAN vol. 2000, no. 26, 1 July 2002 (2002-07-01) & JP 2001 262335 A (NIPPON SHEET GLASS CO LTD), 26 September 2001 (2001-09-26)
- HIROFUMI TAKIKAWA, TSUYOSHI SASAOKA AND TATEKI SAKAKIBARA: "Synthesis of Anatase TiO2 by reactive Vacuum Arc Deposition Method", ELECTRICAL ENGINEERING IN JAPAN, vol. 126, no. 4, 8 August 1997 (1997-08-08), pages 866-872,

## Description

The present invention relates to a method for depositing thin layers of titanium dioxide on support surfaces, using a Physical Vapour Deposition technique, comprising steps of preparing the supports, vaporising and depositing.

Titanium dioxide, TiO₂, is widely used as a surface coating, because of its optical properties. In mineralogical terms, titanium dioxide has a crystalline structure, which may be found in several forms: anatase, rutile or brookite. In particular, anatase is highly reactive and it has marked photocatalytic properties, i.e. it allows the catalysis of numerous oxidation-reduction processes, in the presence of light radiation. Thus, titanium dioxide has a strong photocatalytic activity, especially when it is crystallised in the form of anatase, and it is therefore capable of developing a chemical transformation action on numerous substances, organic or not, normally present in the environment in gaseous or aqueous phase, said action being facilitated by radiation, especially in the case of ultraviolet rays. This photocatalytic property has many technical applications, e.g. the reduction in environmental pollution, water conditioning, air deodorising.

In this light, several methods are known for depositing thin layers of TiO₂ on surfaces. Some method provide for damp treatments, in which the surface to be coated is put in contact with a solution containing titanium dioxide particles. Treatments of this kind are adopted, for example, to obtain cement pastes comprising TiO₂, as described in the patent document MI2002A002019, or to obtain ceramic tiles having a superficial layer of titanium dioxide, as described in the patent document M02002A000344. The methods for depositing TiO₂ layers by damp treatments can provide for the introduction of doping elements, to improve the photocatalytic properties of the deposit, as described in the patent document EP1205243A1. The main drawback of damp treatments is that they are expensive and not very practical, since they require complicated treatments (e.g., cleaning and backing) subsequent to depositing the titanium dioxide layer. Moreover, this type of treatments can only be used to coat surfaces having a certain geometry (typically, planar surfaces).

Methods are also known for depositing thin layers of TiO₂ comprising dry treatments at high temperature (> 400°C), in which titanium dioxide is deposited on the surface starting from gaseous precursors, as described, for example, in the patent document WO00/47797. With regard to dry treatment, the difficulty is to maintain the reaction temperature low, in order to have a high anatase concentration. An additional limitation is that these processes use titanium in its oxidised form, or present in appropriate chemical compounds, hard to obtain and/or dangerous to manipulate due to their toxicity.

Within processes to obtain thin deposits on surfaces, a technique called Physical Vapour Deposition (P.V.D.) is also known. This technique consists of a physical-chemical process in a vacuum, whereby it is possible to obtain, on the surfaces of the materials to be treated, thin depositions (with variable thickness, from a few nanometres to a few tens of microns), compact or with a certain degree of porosity and with control crystal growth. The surface deposits obtained by a P.V.D. technique have peculiar properties, e.g. a high value of hardness, a high resistance to wear with low friction coefficients, a very high chemical stability coupled with high corrosion resistance. Moreover, said deposits are normally non-toxic, anti-allergic, biocompatible and aesthetically pleasing. An additional advantage of P.V.D. processes consists of the nearly total absence of polluting emissions and discharges. These methods substantially comprise three main steps, i.e. preparing the supports and loading the supports into the reaction chamber, vaporisation after obtaining the high vacuum, and deposition. Within the P.V.D. technique, the main differences between one process and another concern the vaporisation step. In this light, different techniques are known, such as cathodic arc vaporisation, electron beam vaporisation, sputtering. In particular, in the cathodic arc vaporisation an electric arc is activated on the metal target which is consequently vaporised as a result of the Joule effect; the electron beam vaporisation process provides for bombarding the metal target with high energy electron beam which melts and vaporises the metal; the sputtering vaporisation process provides for bombarding the metal target with ions of inert gas such as Argon, which displace the metal ions from the target. However, known P.V.D. processes do not provide for the use of massive titanium at the zero valent state to deposit titanium dioxide with photocatalytic properties on ceramic, glassy, polymeric and non-ferrous metallic substrates. In particular, the prior art has no teachings with regard to the steps of the preparation and ionic activation of said substrates, said steps being necessary, within the P.V.D. technique, to provide the deposits with said photocatalytic properties.

Furthermore, technical solutions are known from scientific literature which disclose the deposition of thin layers of TiO2 by applying a magnetron sputtering technique using a pure titanium metal target and Ar:02 as sputtering gas, in particular, we refer to the following documents: 'ZHENG S K ET AL: "photocatalytic activity of nanostractured TiO2 thin films prepared by dc magnetron sputtering method" VACUUM, PERGAMON PRESS, GB, vol. 62, no. 4, 22 June 2001 (2001-06-22), pages 361-366, which discloses depositing a thin layer of TiO2 on a substrate or support with a ionic activation performed only by argon (inert gas), XP002963475 ISSN: 0042-207X', 'ZEMAN P ET AL: "Nano-scaled photocatalytic TiO2 thin films prepared by magnetron sputtering" PREPARATION AND CHARACTERIZATION, ELSEVIER SEQUOIA, NL, vol. 433, no. 1-2, 2 June 2001 (2003-06-02), pages 57-62, XP004428714 ISSN: 0040-6090', 'ZEMAN P ET AL: "Self-cleaning and antifogging effects of TiO2 filmes prepared by radio frequency magnetron sputtering" JOURNAL OF VACUUM SIENCE AND TECHNOLOGY A. VACUUM, SURFACES AND FILMES, AMERICAN INSTITUTE OF PHYSICS, NEW YORK, NY, US, vol. 20, no. 2, March 2002'

Thus, the prior art makes available several methods for obtaining titanium dioxide coatings, but it is characterised by numerous drawbacks and limitations, which do not allow to deposit a thin layer of photocatalytically active titanium dioxide on a ceramic, glassy, polymeric or non ferrous metallic support surface, starting from massive titanium, at the zero valent metal state, and at relatively low temperatures.

From Electrical Engineering in Japan, vol. 126, no 4, 8 August 1997, pages 886-872 is known the deposition of titanium dioxide through the use of vacuum arc deposition. The substrate is cleaned, then prepared as oxygen is first supplied to the chamber while at the same time arc is ignited, thereafter the film begins to form as titanium deposits from the cathode.

An object of the present invention is to eliminate the aforesaid drawbacks and to make available a method for depositing thin layers of titanium dioxide on support surfaces.

Said objects are fully achieved by the method of the present invention, which is characterised by the content of the appended claims.

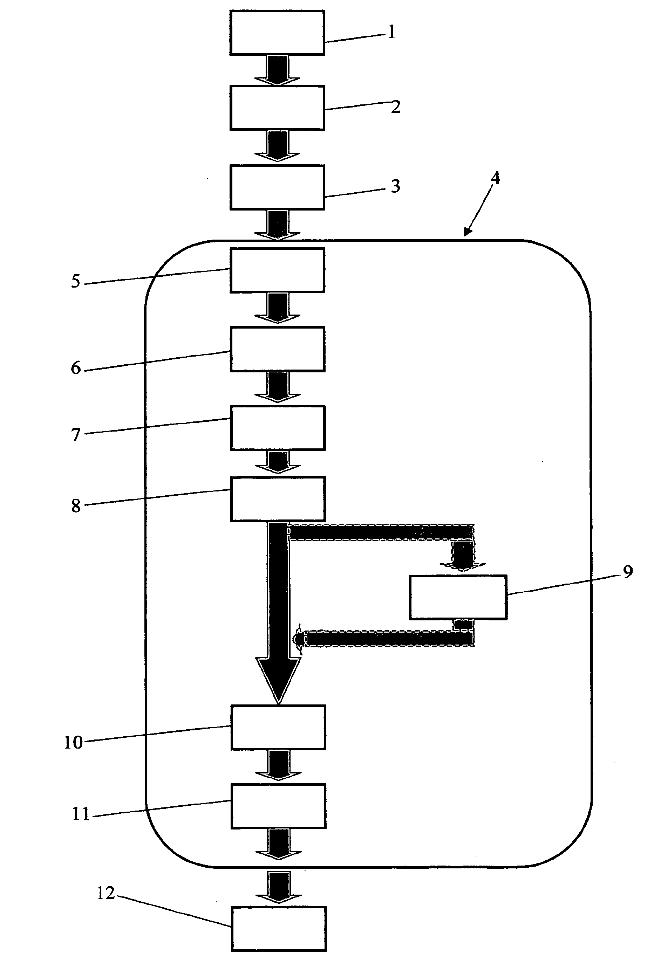

This and other characteristics shall become more readily apparent from the following description of the invention illustrated by the accompanying drawing table, in which the figure schematically shows the steps of the process of the present invention. The process of the present invention comprises the following operative steps, numbered with the same reference numbers as the accompanying figure:
1 insertion of an artefact, on whose surfaces a layer of titanium dioxide is to be deposited, into a vacuum-seal chamber, preferably made of steel, anchored to fixed or rotating equipment;
2 preliminary cleaning of the surfaces on which the deposit is to be obtained;
3 mounting targets of massive titanium, at the zero valent state and loading the depositing machines;
4 starting the deposition cycle;
5 preheating the artefact, preferably by means of infrared radiation, to a temperature value that depends on the nature of the substrate, in particular, about 150°C ÷ 400°C in the case of metallic, ceramic or glassy substrates, 100°C or lower temperatures, in the case of polymeric substrates;
6 evacuating air from the chamber, to obtain vacuum, substantially in the 10⁻² ÷ 10⁻⁵ Pa range;
7 executing one or more steps of ionic cleaning and activation of the surfaces to be coated with bombardment with ions of an active gas, such as nitrogen, oxygen, carbon dioxide or hydrocarbons, by applying a high electrical potential;
8 vaporising a target of massive titanium, in the zero valent state, in one or two steps, preferably by applying an electrical arc;
9 possibly vaporising a target of titanium or other massive metal, in the zero valent state, in one or two steps, to obtain a supporting metallisation;
10 depositing, in one or more steps, compounds comprising titanium dioxide, obtained by introducing into the chamber controlled flows of reactive gases, possibly also mixed with inert gases, which, combining with the ions of the metal, originate the deposit by effect of a phenomenon of condensation on the surface to be coated, which is bombarded with metal ions made available by the previous vaporisation step 8; in this step, a negative electrical potential can be applied;
11 cooling the artefact;
12 discharging the deposition machines.

It should be observed that, during the vaporisation and deposition step, the production of metal ions from the targets and their path in the deposition chamber they can be controlled by applying appropriate fixed and/or variable magnetic fields. Moreover, in the deposition step 10, pressure is maintained roughly in the 0.1 ÷ 10 Pa range.

Therefore, the described method enables to obtain deposits of thin layers of titanium dioxide, starting from massive metallic Titanium, through a process that is originally applied to ceramic, glassy, polymeric and non ferrous metallic supports. Said method originally allows to control the crystallisation of titanium dioxide, acting on the parameters that regulate the deposition cycles, in particular temperatures, gaseous mixtures, currents, voltages and working times, in order to deposit titanium dioxide in the form of anatase, or anatase and rutile, or anatase together with amorphous phase, or anatase and rutile together with amorphous phase.

An additional advantage of the method of the present invention is the ability to obtain the titanium dioxide deposit on supports of different nature, in particular ceramics, refractory materials in general, glasses and polymers, steel in all its alloys, copper and its alloys, aluminium and its alloys, nickel, cobalt, and their alloys, titanium and its alloys, zinc and its alloys, gold, silver and their alloys.

## Claims

1. A method for depositing a thin layer of TiO₂ or compounds comprising TiO₂ on a support, using a Physical Vapour Deposition technique, comprising steps of:
1-insertion of an artefact, on whose surfaces a layer of titanium dioxide is to be deposited, into a vacuum-seal chamber, preferably made of steel, anchored to fixed or
rotating equipment;
2-preliminary cleaning of the surfaces on which the deposit is to be obtained;
3-mounting targets of massive titanium, at the zero valent state and loading depositing machines;
4-starting the deposition cycle;
5-preheating the artefact, preferably by means of infrared radiation, to a temperature value that depends on the nature of the substrate, in particular, 150°C ÷ 400°C in the case of metallic, ceramic or glassy substrates, 100°C or lower temperatures, in the case of polymeric substrates;
6-evacuating air from the chamber, to obtain vacuum, in the 10⁻² ÷ 10⁻⁵ Pa range;
7-executing one or more steps of ionic cleaning and
activation of the surfaces to be coated with bombardment with ions of an active gas, such as nitrogen, oxygen, carbon dioxide or hydrocarbons, by applying a high electrical potential;
8-vaporising a target of massive titanium, in the zero valent state, in one or two steps, by applying an electrical arc;
9-possibly vaporising a target of titanium or other massive metal, in the zero valent state, in one or two steps, to obtain a supporting metallisation;
10-depositing, in one or more steps, compounds comprising titanium dioxide, obtained by introducing into the chamber controlled flows of reactive gases, possibly also mixed with inert gases, which, combining with the ions of the metal, originate the deposit by effect of a phenomenon of condensation on the surface to be coated,
which is bombarded with metal ions made available by the previous vaporisation step 8; in this step, a negative electrical potential can be applied;
11-cooling the artefact;
12-discharging the deposition machines.

2. Method as claimed in claim 1, which comprises a step of control over crystallisation, to deposit TiO₂ prevalently in the form of anatase.

3. Method as claimed in claim 1, which comprises a step of control over crystallisation, to deposit TiO₂ prevalently in the combined amorphous and anatase form.

4. Method as claimed in claim 1, which comprises a step of control over crystallisation, to deposit TiO₂ prevalently in the combined anatase and rutile form.

5. Method as claimed in claim 1, which comprises a step of control over crystallisation, to deposit TiO₂ prevalently in the combined amorphous, anatase and rutile form.

6. Method as claimed in claim 1, wherein during the vaporisation and deposition step, the production of metal ions from targets and their path in a deposition chamber are controlled by applying fixed and/or variable magnetic fields.

## Patentansprüche

1. Verfahren zur Abscheidung einer Dünnschicht von TiO₂ oder Verbindungen, die TiO₂ enthalten, auf einem Träger unter Nutzung einer Technik zur physikalischen Gasphasenabscheidung, umfassend folgende Schritte:
1 Einfügen eines Artefakts, auf dessen Oberflächen eine Titandioxidschicht abzuscheiden ist, in eine vakuumabgedichtete Kammer, vorzugsweise bestehend aus Stahl, verankert mit einem fixierten oder rotierenden Gerät;
2 Vorreinigung der Oberflächen, auf denen die Abscheidung zu erhalten ist;
3 Montieren von Targets aus massivem Titan im nullwertigen Zustand und Laden von Abscheidungsmaschinen;
4 Starten des Abscheidungszyklus;
5 Vorheizen des Artefakts, vorzugsweise durch Infrarotbestrahlung, auf einen Temperaturwert, der von der Art des Substrats abhängt, insbesondere 150°C bis 400 °C bei metallischen, keramischen oder Glassubstraten, 100 °C oder niedriger bei polymerischen Substraten;
6 Ausstoßen von Luft aus der Kammer, um ein Vakuum im Bereich 10⁻² bis 10⁻⁵ Pa zu erhalten;
7 Durchführen von einem oder mehreren Schritten der Ionenreinigung und Aktivierung der zu beschichtenden Oberflächen durch den Ionenbeschuss eines aktiven Gases wie Stickstoff, Sauerstoff, Kohlendioxid oder Kohlenwasserstoffe durch das Anlegen eines hohen elektrischen Potenzials;
8 Zerstäubung eines Targets aus massivem Titan im nullwertigen Zustand in einem oder zwei Schritten durch Anwenden eines Lichtbogens;
9 möglichst Zerstäubung eines Targets aus massivem Titan oder einem anderen massiven Metall im nullwertigen Zustand in einem oder zwei Schritten, um eine unterstützende Metallisierung zu erhalten;
10 Abscheiden in einem oder mehreren Schritten von Verbindungen, umfassend Titandioxid, erhalten durch das Einführen in die Kammer von kontrollierten Strömen reaktiver Gase, möglichst auch vermischt mit Inertgasen, die durch die Kombination mit den Ionen des Metalls die Abscheidung durch ein Kondensationsphänomen auf der zu beschichtenden Oberfläche erzeugen, auf der ein Metallionen-Beschuss erfolgt, bereitgestellt durch die vorherige Zerstäubung aus Schritt 8; in diesem Schritt kann ein negatives elektrisches Potenzial angelegt werden;
11 Kühlen des Artefakts;
12 Entladen der Abscheidungsmaschinen.

2. Verfahren nach Anspruch 1, das einen Schritt der Kristallisationsüberwachung umfasst, um TiO₂ vorwiegend als Anatas abzuscheiden.

3. Verfahren nach Anspruch 1, das einen Schritt der Kristallisationsüberwachung umfasst, um TiO₂ vorwiegend kombiniert amorph und als Anatas abzuscheiden.

4. Verfahren nach Anspruch 1, das einen Schritt der Kristallisationsüberwachung umfasst, um TiO₂ vorwiegend kombiniert als Anatas und als Rutil abzuscheiden.

5. Verfahren nach Anspruch 1, das einen Schritt der Kristallisationsüberwachung umfasst, um TiO₂ vorwiegend kombiniert amorph, als Anatas und als Rutil abzuscheiden.

6. Verfahren nach Anspruch 1, wobei während des Schritts der Zerstäubung und Abscheidung die Erzeugung von Metallionen aus Targets und deren Weg in einer Abscheidungskammer durch das Anwenden fixierter und/oder variabler Magnetfelder kontrolliert werden.

## Revendications

1. Procédé de dépôt d'une couche mince de TiO₂ ou de composés comprenant du TiO₂ sur un support, en utilisant une technique de déposition physique en phase vapeur, comprenant les étapes suivantes :
1 insérer un objet, à la surface duquel une couche de dioxyde de titane sera déposée dans une chambre à vide scellée, de préférence en acier, ancrée à un équipement fixe ou tournant ;
2 nettoyer préalablement la surface sur laquelle le dépôt sera obtenu ;
3 monter des cibles de titane massif, à un état de valence zéro et charger les machines de dépôt ;
4 commencer le cycle de déposition ;
5 préchauffer l'objet, de préférence par le biais d'un rayonnement infrarouge, à une valeur de température, qui dépend de la nature du substrat, comprise, en particulier, entre 150 et 400°C dans le cas de substrats métallique, céramique ou verre, entre 100°C et des températures inférieures, dans le cas de substrats polymères ;
6 évacuer l'air de la chambre pour obtenir un vide compris entre 10⁻² et 10⁻⁵ Pa ;
7 exécuter une ou plusieurs étapes de nettoyage et d'activation ionique des surfaces à revêtir par bombardement d'ions d'un gaz actif tel que l'azote, l'oxygène, le dioxyde de carbone ou d'hydrocarbures, en appliquant un potentiel électrique élevé ;
8 vaporiser une cible de titane massif, à l'état de valence zéro, en une ou deux étapes en appliquant un arc électrique ;
9 si possible, vaporiser une cible de titane ou de tout autre métal massif, à l'état de valence zéro, en une ou deux étapes pour obtenir une métallisation de support ;
10 déposer, en une ou plusieurs étapes, des composés comprenant du dioxyde de titane, obtenus en introduisant dans la chambre des écoulements contrôlés de gaz réactifs, si possible, aussi mélangés à des gaz inertes qui, en se combinant aux ions du métal, sont à l'origine du dépôt, sous l'effet d'un phénomène de condensation sur la surface à revêtir, étant bombardé par des ions métalliques mis à disposition par l'étape précédente n°8 de vaporisation ; dans cette étape, un potentiel électrique négatif peut être appliqué ;
11 refroidir l'objet ;
12 décharger les machines de dépôt.

2. Procédé selon la revendication 1, comprenant une étape de contrôle sur la cristallisation pour déposer le TiO₂ principalement sous forme d'anatase.

3. Procédé selon la revendication 1, comprenant une étape de contrôle sur la cristallisation pour déposer le TiO₂ principalement sous la forme combinée amorphe et d'anatase.

4. Procédé selon la revendication 1, comprenant une étape de contrôle sur la cristallisation pour déposer le TiO₂ principalement sous la forme combinée d'anatase et rutile.

5. Procédé selon la revendication 1, comprenant une étape de contrôle sur la cristallisation pour déposer le TiO₂ principalement sous la forme combinée amorphe, d'anatase et rutile.

6. Procédé selon la revendication 1, dans lequel lors des étapes de vaporisation et de déposition, la production d'ions métalliques à partir des cibles et de leur trajectoire dans une chambre de dépôt sont contrôlées en appliquant des champs magnétiques variables et/ou fixes.
